(19) **Europäisches Patentamt / European Patent Office / Office européen des brevets**

(11) **EP 0 905 752 B1**

(12) **EUROPEAN PATENT SPECIFICATION**

(45) Date of publication and mention
of the grant of the patent:
**19.05.2010 Bulletin 2010/20**

(51) Int Cl.:
***H01L 21/285*** (2006.01)

(21) Application number: **98101748.6**

(22) Date of filing: **02.02.1998**

(54) **Method for fabricating conductive electrode for semiconductor device**

Verfahren zur Herstellung einer leitenden Elektrode auf einer Halbleitervorrichtung

Procédé de fabrication d'une électrode conductrice sur un dispositif semiconducteur

(84) Designated Contracting States:
**DE FR GB**

(30) Priority: **29.09.1997 KR 9749798**

(43) Date of publication of application:
**31.03.1999 Bulletin 1999/13**

(73) Proprietor: **LG Semicon Co., Ltd.**
**Cheongju-si,**
**Chungcheongbuk-do (KR)**

(72) Inventors:
• **Byun, Jeong Soo,**
**Songhak Samik Apt. 102-601**
**Cheongju-si,**
**Chungcheongbuk-do (KR)**
• **Lee, Byung Hak**
**Cheongju-si,**
**Chungcheongbuk-do (KR)**

(74) Representative: **TER MEER - STEINMEISTER &**
**PARTNER GbR**
**Patentanwälte**
**Mauerkircherstrasse 45**
**81679 München (DE)**

(56) References cited:
**EP-A- 0 497 596**   **EP-A- 0 746 012**
**EP-A- 0 746 027**   **US-A- 4 504 521**
**US-A- 4 912 543**   **US-A- 5 525 543**
**US-A- 5 576 228**   **US-A- 5 665 646**

• **PATENT ABSTRACTS OF JAPAN vol. 012, no. 367 (E-664), 30 September 1988 (1988-09-30) & JP 63 120419 A (MATSUSHITA ELECTRONICS CORP), 24 May 1988 (1988-05-24)**
• **PATENT ABSTRACTS OF JAPAN vol. 006, no. 234 (E-143), 20 November 1982 (1982-11-20) & JP 57 134928 A (TOKYO SHIBAURA DENKI KK), 20 August 1982 (1982-08-20)**

EP 0 905 752 B1

**Description**

BACKGROUND OF THE INVENTION

Field of the Invention

The present invention relates to a semiconductor device, and more particularly, to a method for fabricating a semiconductor device, which is suitable for improving a step coverage and a resistivity.

Discussion of the Related Art

In general, as the semiconductor devices are highly integrated, a width of wiring in the semiconductor devices is reduced, causing problems, such as drop in operation speed due to consequential increase of a resistance of the wiring. And, the formation of a thicker wiring as a wiring width is reduced used as a counter measure on the increased sheet resistivity of the wiring causes a problem that a fabrication process for the device becomes complicated with less yield because of a greater step coverage of the wiring. In order to solve these problems, a refractory metal silicide, such as tungsten silicide ($WSi_x$), titanium silicide($TiSi_2$), or cobalt silicide($CoSi_2$) is formed on a polysilicon layer in an intention for preventing an increase of resistivity (hereafter, a refractory metal silicide formed on a polysilicon layer is called "polycide"). However, though this can improve the resistivity and step coverage to a some extent, a method for forming a polycide which can improve further is in need.

The document US 4 504 521 shows a prior art method for the formation of a low resistivity metal silicide.

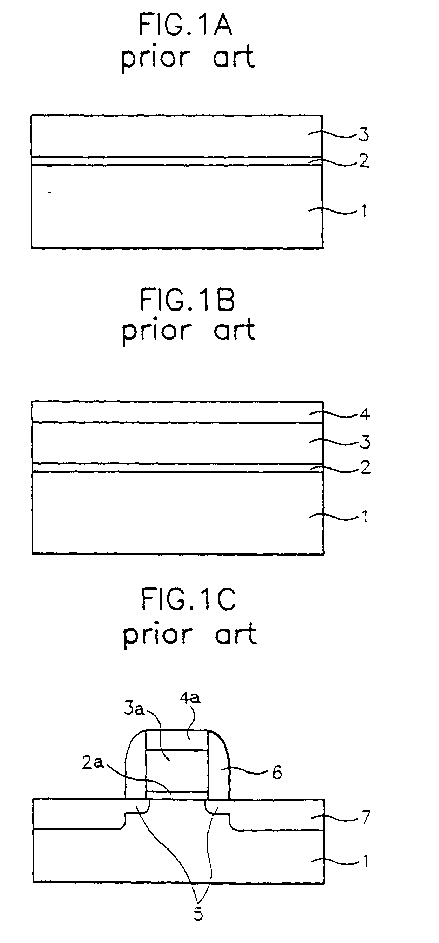

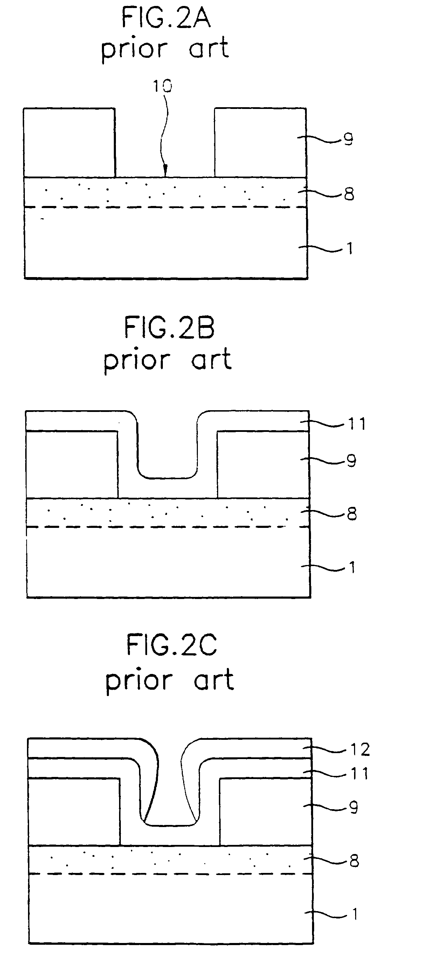

A conventional method for fabricating a semiconductor device will be explained with reference to the attached drawings. Figs. 1a - 1c illustrate sections showing process steps of a first conventional method for fabricating a semiconductor device, and Figs. 2a - 2c illustrate sections showing process steps of a second conventional method for fabricating a semiconductor device. A polycide fabrication process used for reducing a resistivity and a step coverage in a semiconductor device can be applied to a process for forming a gate electrode or a bitline.

The process steps of the first conventional method for fabricating a semiconductor device in which the polycide fabrication process is applied to formation of a gate electrode will be explained.

Referring to Fig. 1a, the process starts with deposition of a first oxide film 2 on a semiconductor substrate 1 and deposition of a polysilicon layer 3 on the first oxide film 2. The polysilicon layer 3 is doped with P type impurities and soluble in water. The doping of the polysilicon layer 3 may be done by ion injection after deposition of the polysilicon layer 3 is completed, or by deposition of $POCl_3$, or by a continuous injection of a doping gas, such as $PH_3$, while depositing the polysilicon layer. For removing a natural oxide film(or glass) which may remain on the polysilicon layer 3 during the process of forming the polysilicon 3 as shown in Fig. 1b, the process resultant is dipped into HF solution for cleaning. A chemical vapor deposition of $SiH_4$ or $SiH_2Cl_2$ with tungsten hexafluoride($WF_6$) gas is conducted to form a tungsten silicide layer 4, to form a polycide layer. As shown in Fig. 1c, the tungsten silicide layer 4, polysilicon layer 3 and the first oxide film 2 are subjected to photolithography to make an anisotropic etching of the layers 2, 3 and 4 with a mask for forming a gate electrode used, resulting to form a stack of a gate cap silicide layer 4a, a gate electrode 3a and a gate oxide film 2a. A lightly doped drain(LDD) region 5 is formed in the semiconductor substrate 1 on each side of the gate electrode 3a. A second oxide film is deposited on the entire surface and subjected to anisotropic etching to remove the second oxide film, forming sidewall insulating films 6 on both sides of the gate cap silicide layer 4a, gate electrode 3a and gate oxide film 2a. Portions of the semiconductor substrate 1 on outward sides of the sidewall insulating films 6, excluding a portion under the gate electrode 3a, are heavily doped, to form source/drain regions 7 therein.

The process steps of the second conventional method for fabricating a semiconductor device in which the polycide fabrication process is applied to formation of a bitline will be explained.

Referring to Fig. 2a, the process steps start with formation of an N type impurity doped layer 8 in a portion of a P type semiconductor substrate 1. A chemical vapor deposition is conducted to form an interlayer insulating layer 9 on the semiconductor substrate 1, which is selectively removed to form a contact hole 10 exposing the N type impurity doped layer 8. As shown in Fig. 2b, a polysilicon layer 11 is formed on the entire surface. The polysilicon layer 11 is doped with P type impurities and soluble in water. The doping of the polysilicon layer I 1 may be done by ion injection after deposition of the polysilicon layer 3 is completed, or by deposition of $POCl_3$, or by a continuous injection of a doping gas, such as $PH_3$, while depositing the polysilicon layer. For removing a natural oxide film(or glass) which may remain on the polysilicon layer 11 during the process of forming the polysilicon 11 as shown in Fig. 2c, the process resultant is dipped into HF solution for cleaning. A chemical vapor deposition of $SiH_4$ or $SiH_2Cl_2$ with tungsten hexafluoride($WF_6$) gas is conducted to form a tungsten silicide layer 12 on the polysilicon layer 11, which is subjected to selective patterning to form a bitline of the polycide layer.

In the conventional polycide fabrication process, a doped polysilicon layer is formed on a substrate, and the polysilicon layer is cleaned with HF solution to remove a natural oxide film present on the surface of the polysilicon layer, which is then placed in a chamber and maintained at an elevated temperature over 500 deg. C while injecting $SiH_4$ or $SiH_2Cl_2$, and $WF_6$ gases into the chamber, to form tungsten silicide(WSix) on the doped polysilicon layer. In comparison to a tungsten silicide(WSix) with $2<x\leq3.2$, the aforementioned tungsten silicide contains excessive silicon. If the tungsten silicide containing excessive silicon is subjected to heat treatment, a resistivity of the tungsten silicide is lowered compared to the case when the tungsten silicide is not formed, resulting in an improvement in operational characteristics of the device.

However, the conventional method for fabricating a semiconductor device has the following problems.

First, the cleaning of the doped polysilicon with HF solution for removing the natural oxide film present on the surface of the doped polysilicon causes to leave an undoped polysilicon layer on the surface of the doped polysilicon layer. And, the formation of tungsten silicide on the doped polysilicon layer with an undoped polysilicon surface leads to form a silicon excess tungsten silicide which has a resistivity higher than 100 $\mu\Omega\cdot$cm even after heat treatment despite the fabrication process becomes stable. Therefore, in order to lower the resistivity of 200 $\mu\Omega\cdot$cm of polysilicon in formation of a gate electrode, though the tungsten silicide layer is formed on the polysilicon layer by applying the conventional polycide fabrication process, the tungsten silicide layer can only lower the resistivity of the polysilicon layer by approximately half, that is not enough for a highly integrated device in which a line width is reduced below 0.25 $\mu$m.

Second, a bitline formed with a tungsten silicide layer formed reduced by $SiH_4$ or $SiH_2Cl_2$ according to the second conventional method has a step coverage greater than a bitline formed with a tungsten metal layer. Due to this, a problem is caused that the bitline can not fully fill a contact hole in a device fabrication process which involves a contact hole size below 0.25 $\mu$m with an aspect ratio greater than 3 as shown in Fig. 2c

## SUMMARY OF THE INVENTION

Accordingly, the present invention is directed to a method tor fabricating a semiconductor device that substantially obviates one or more of the problems due to limitations and disadvantages of the related art.

An object of the present invention is to provide a method for forming a tungsten silicide which is suitable for improving a step coverage and resistivity, and a method for fabricating a semiconductor device applying the same.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

To achieve these and other advantages and in accordance with the purpose of the present invention, as embodied and broadly described, the method of claim 1 should be carried out.

It is to be understood that both the foregoing general description and the following detailed description are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention:

In the drawings:

Figs. 1a - 1c illustrate sections showing process steps of a first conventional method for fabricating a semiconductor device;

Figs. 2a - 2c illustrate sections showing process steps of a second conventional method for fabricating a semiconductor device;

Figs. 3a - 3c illustrate sections showing process steps of a method for fabricating a semiconductor device in accordance with a first preferred embodiment of the present invention;

Figs. 4a - 4d illustrate sections showing process steps of a method for fabricating a semiconductor device in accordance with a second preferred embodiment of the present invention;

Fig. 5 illustrates a section showing a method for forming a metal silicide in accordance with a third preferred embodiment of the present invention;

Fig. 6 illustrates a graph showing a $PH_3$ flow rate vs. a resistivity of a tungsten silicide layer(WSix) in deposition of a polysilicon layer according to the method for fabricating a semiconductor device of the present invention;

Fig. 7 illustrates a graph showing a sputtering time vs. a silicon atoms/tungsten atoms ratio in a tungsten silicide layer(WSix) for different $PH_3$ flow rates in deposition of a polysilicon layer according to the present invention;

Fig. 8 illustrates a graph showing a deposition temperature of a tungsten silicide layer (WSix) vs. a composition of the tungsten silicide layer of the present invention; and,

Fig. 9 illustrates a graph showing a reaction temperature of a tungsten silicide layer formed according to different source gases injected into a doped polysilicon layer of the present invention vs. formation energy

DETAILED DESCRIPTION OF THE PREFERRED EMBODIMENT

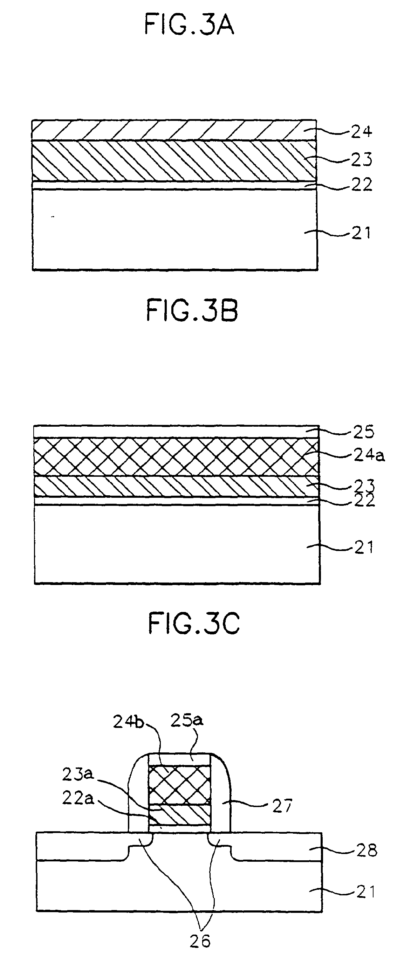

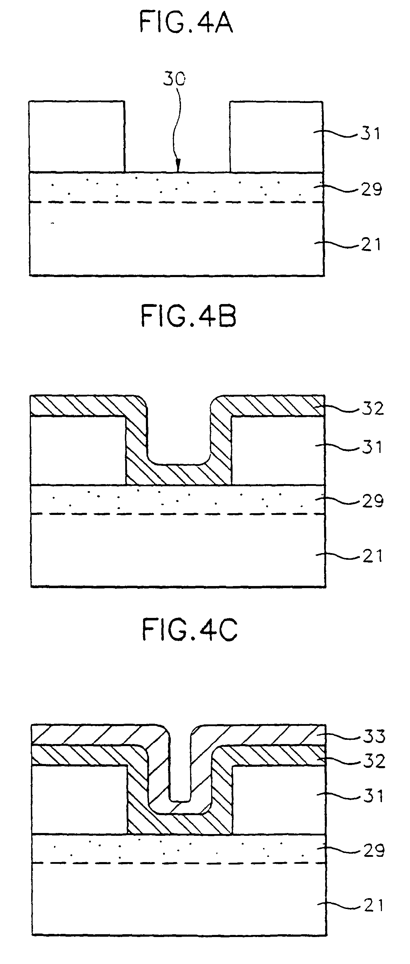

Reference will now be made in detail to the preferred embodiments of the present invention, examples of which are illustrated in the accompanying drawings Figs. 3a ~ 3c illustrate sections showing process steps of a method for fabricating a semiconductor device in accordance with a first preferred embodiment of the present invention, and Figs. 4a ~ 4d illustrate sections showing process steps of a method for fabricating a semiconductor device in accordance with a second preferred embodiment of the present invention. The polycide fabricating process used for reducing a resistivity of a semiconductor device is applicable to formation of a gate electrode and a bitline.

Referring to Fig. 3a, the method for fabricating a semiconductor device in accordance with a first preferred embodiment of the present invention starts with depositing a first oxide film 22 on a semiconductor substrate 21 to a thickness of 80 Å. Then, an ICT(Integrated Cluster Tool) is used for forming a doped polysilicon layer 23 to a thickness of 1000 Å at 660 deg. C and 80 Torr. The polysilicon layer 23 is deposited using a source gas of $H_2$ containing 50% of $SiH_4$ and 1% of $PH_3$. Then, the semiconductor substrate 21 with the doped polysilicon layer 23 deposited thereon is transferred to a chamber for use in depositing a first tungsten silicide layer 24 without exposure to the atmosphere(i.e., without breakage of a vacuum). Then, the first tungsten silicide layer 24 is deposited on the polysilicon layer 23. The first tungsten silicide layer 24 is deposited using $WF_6$ and $SiH_4$ or $SiH_2Cl_2$ and $WF_6$ gases as source gases; if $WF_6$ and $SiH_4$ are used, the flow rates are 4 and 175 sccm respectively, and the deposition pressure is fixed at 0.9 Torr while varying deposition temperature in a range of 500 ~ 600 deg. C, resulting to deposit a tungsten silicide layer containing an excessive tungsten. That is, a tungsten silicide layer satisfying a condition of $0.5 \leq x < 2$ in WSix is deposited. If the first tungsten silicide layer 24 is deposited at a temperature below 555 deg. C, the first tungsten silicide layer 24 is converted into amorphous, and If the first tungsten silicide layer 24 is deposited at a temperature above 555 deg. C, the first tungsten silicide layer 24 has amorphous phases and crystalline phases existing together. And because the doped polysilicon layer 23 is not exposed to the atmosphere during formation of the first tungsten silicide layer 24, that eliminates the conventional requirement for cleaning with HF solution for removing the natural oxide film, no undoped layer is formed on the surface of the doped polysilicon layer, causing the first tungsten silicide layer 24 to contain more tungsten atoms than silicon atoms. As shown in Fig. 3b, RTA(Rapid Thermal Annealing) is conducted at a temperature in a range of 400 ~ 1100 deg. C(most preferably 900 ~ 1000 deg. C) for 30 seconds under a gaseous ambient containing nitrogen atoms, such as nitrogen($N_2$), argon(Ar), or $NH_3$. In this instance, the excessive tungsten atoms in the first tungsten silicide 24 and the doped polysilicon layer 23 make reaction leading to form a second tungsten silicide layer 24a having a tetragonal phase crystal structure. The second tungsten silicide layer 24a, having a tetragonal phase crystal structure, has a lower resistivity than the resistivity of the conventional heat treated silicon excess tungsten silicide. And, the silicon nitride film 25 formed on the surface of the second tungsten silicide layer 24a in the process of the heat treatment of the first tungsten silicide layer 24 under a gaseous ambient containing nitrogen atoms, not only prevents diffusion of N type or P type dopant, but also can be used as a protection film. As shown in Fig. 3c, a mask for forming a gate electrode is used in an anisotropic etching of the second tungsten silicide layer 24, the polysilicon layer 23 and the first oxide film 22, to form a gate cap silicide layer 24b, a gate electrode 23a, and a gate oxide film 22a. LDD(Lightly Doped Drain) regions 26 are formed in the semiconductor substrate 21 on both sides of the gate electrode 23a, and a second oxide film is formed on the entire surface and subjected to anisotropic etching to remove the second oxide film, to form sidewall insulating films 27 at sides of the gate cap nitride film 25a, the gate cap tungsten silicide film 24b, the gate electrode 23a and the gate oxide film 22a. Then, portions of the semiconductor substrate 21 on both sides of the sidewall insulating films 27 excluding the gate electrode 23a are heavily doped to form source/drain regions 28 therein.

Next, a method for fabricating a semiconductor device in accordance with a second embodiment of the present invention as applied to bitline formation will be explained.

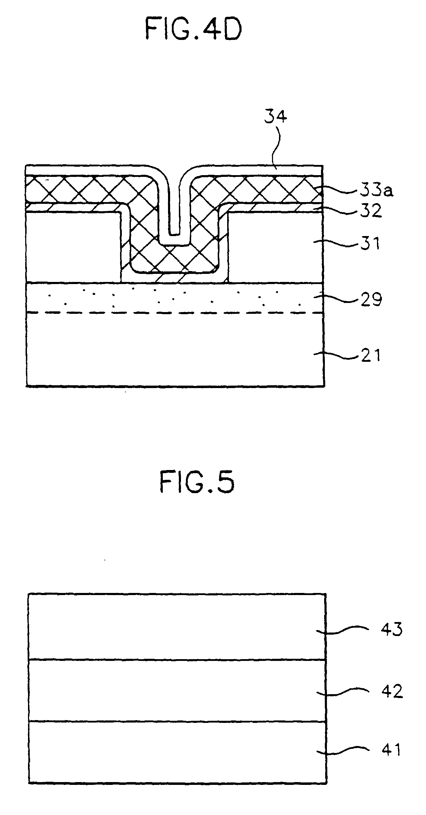

Referring to Fig. 4a, N type impurity ions are injected into a P type semiconductor substrate 21 to form an N type impurity injected layer 29 in a certain portion of the P type semiconductor substrate 21. An interlayer insulating layer 31 of a nitride film or oxide film is deposited on the entire surface and subjected to anisotropic etching to expose the N type impurity injected layer 29, to form a contact hole 30 on the N type impurity injected layer 29. As shown in Fig. 4b, a polysilicon layer 32 is deposited on the surface in the contact hole 30 and on the interlayer insulating layer 31. In this instance, the polysilicon layer 32 is deposited using a source gas of $H_2$ containing 50 % $SiH_4$ and 1 % $PH_3$. Then, as shown in Fig. 4c, the semiconductor substrate 21 with the doped polysilicon layer 32 deposited thereon is transferred to a chamber for use in depositing a first tungsten silicide layer 33 without exposure to the atmosphere. Then, the first tungsten silicide layer 33 is deposited on the polysilicon layer 32. As explained in association with Fig. 3a, the first tungsten silicide layer 33 is deposited using $WF_6$ and $SiH_4$ or $SiH_2Cl_2$ and $WF_6$ gases as source gases; if $WF_6$ and $SiH_4$ are used, the flow rates are 4 and 175 seem respectively, and the deposition pressure is fixed at 0.9 Torr while varying deposition temperature in a range of 500 ~ 600 deg. C, resulting to deposit a tungsten silicide layer containing an excessive tungsten. That is, a tungsten silicide layer satisfying a condition of 0 5≤x<2 in WSix is deposited. If the first tungsten silicide layer 33 is deposited at a temperature below 555 deg C, the first tungsten silicide layer 33 is converted into amorphous, and If the first tungsten silicide layer 33 is deposited at a temperature above 555 deg. C, the first tungsten silicide layer 33 has amorphous phases and crystalline phases existing together. And, because the doped polysilicon layer 32 is not exposed to the atmosphere during formation of the first tungsten silicide layer 33, that eliminates the conventional requirement for cleaning with HF solution for removing the natural oxide film, no undoped layer is formed on the surface of the doped polysilicon layer, causing the first tungsten silicide layer 33 to contain more tungsten atoms than silicon atoms. As shown in Fig. 4d, RTA(Rapid Thermal Annealing) is conducted at a temperature in a range of 400 ~ 1100 deg. C(most preferably 900 ~ 1000 deg. C) for 30 seconds under a gaseous ambient containing nitrogen atoms, such as nitrogen($N_2$), argon(Ar), or $NH_3$. In this instance, the excessive tungsten atoms in the first tungsten silicide layer 33 and the doped polysilicon layer 32 make reaction leading to form a second tungsten silicide layer 33a having a tetragonal phase crystal structure. The second tungsten silicide layer 33a, having a tetragonal phase crystal structure, has a lower resistivity than the resistivity of the conventional heat treated silicon excess tungsten silicide, because the second tungsten silicide 33a has a grain size greater than a grain size of the conventional tungsten silicide layer. And, when the first tungsten silicide layer 33 is heat treated in a gaseous ambient containing nitrogen atoms, as the grain size thus becomes greater, the silicon atoms existing in the first tungsten silicide layer 33 are segregated to the surface of the first tungsten silicide layer 33, to form a silicon nitride film 34 on the surface of the second tungsten silicide layer 33a, consuming the polysilicon layer 32 to cause its thickness thinner. The silicon nitride film 34 prevents the N type or P type dopant in the polysilicon layer 32 from being diffused. And, the first tungsten silicide layer 33 may be injected of ions before the RTA process, to convert the first tungsten silicide layer 33 into amorphous That is, as the first tungsten silicide layer 33 has a crystalline layer on an amorphous layer, ions of phosphorus(P), boron(B), or arsenic (As) are injected into the crystalline layer to a dose of 1E15 ~ 5E15 cm$^{-3}$ at an injection energy of 45 ~ 55 KeV in case ofphosphorus(P), of 10 ~ 20 KeV in case of boron(B), and of 55 ~ 65 KeV in case of arsenic(As).

The second tungsten silicide layer 33a of the present invention is better than the conventional tungsten silicide ($WSi_2$) layer which is formed by heat treating a tungsten in that the second tungsten silicide layer 33a of the present invention has no possibility of defect occurrence during fabrication coming from excessive reaction of the silicon atoms present on the semiconductor substrate 21 before formation of the second tungsten silicide layer 33a with the semiconductor substrate 21 during the heat treatment. Thus, the method for fabricating a semiconductor device in accordance with the second embodiment of the present invention is completed.

In the third embodiment of the present invention, a silicon layer is formed on upper and under sides of a metal silicide layer in a method for forming a gate electrode or a data line. Fig. 5 illustrates a section showing a method for forming a metal silicide in accordance with a third preferred embodiment of the present invention.

An ICT(Integrated Cluster Tool) is used in formation of a first polysilicon layer 41 at 660 deg. C and 80 Torr to a thickness of 1000 Å and the first polysilicon layer 41 is doped. Or, alternatively, the doped polysilicon layer 41 may be obtained by depositing a polysilicon layer using a source gas of $H_2$ containing 50 % $SiH_4$ and 1 % $PH_3$. The substrate having the first polysilicon deposited thereon is transferred to a chamber for use in deposition of a first tungsten silicide layer 42 without exposure to the atmosphere(i.e., without breakage of a vacuum), and then the first tungsten silicide layer 42 is formed on the doped first polysilicon layer 41. In this instance the first tungsten silicide layer 42, which can be formed according to a method identical to the first or second embodiment methods, is amorphous or amorphous and crystalline existing together and contains excessive tungsten. And, a second polysilicon layer 43 is formed on the first tungsten silicide layer 42 to a thickness of 0.05 ~ 0.4 times of the tungsten silicide layer 42, and subjected to RTA(Rapid Thermal Annealing) at a temperature ranging 400 ~ 1100 deg. C for 30 seconds, causing reaction between the excessive tungsten atoms in the first tungsten silicide layer 42 and the doped first, and second polysilicon layers 41 and 43 leading to form a second tungsten silicide layer of tetragonal phase. This tetragonal phase second tungsten silicide layer shows, not only a lower resistivity than the conventional one, but also better properties than ones formed by the first and second embodiments. That is, the diffusion of silicon atoms from the underlying polysilicon layer to the overlying first tungsten silicide layer during the heat treatment in the first and second embodiments, causing grain sizes in the first tungsten silicide layer to become greater, may make the second tungsten silicide layer bent. However, in the third embodiment, as the silicon atoms are fed to the first tungsten silicide layer from all of the first, and second polysilicon layers during the heat treatment, there is no possibility of bent. Alike the first, and second embodiments, metals and dopants may also be varied in this third embodiment.

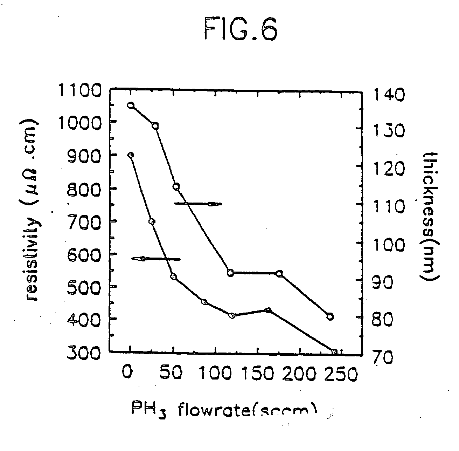

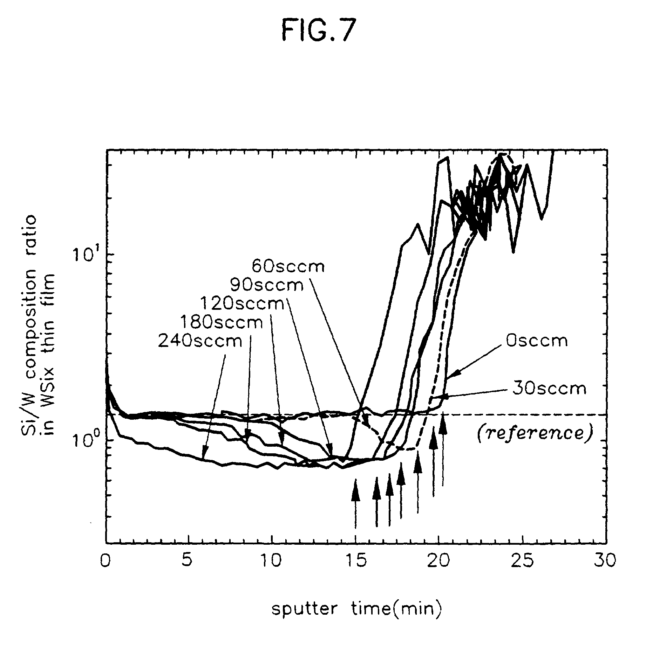

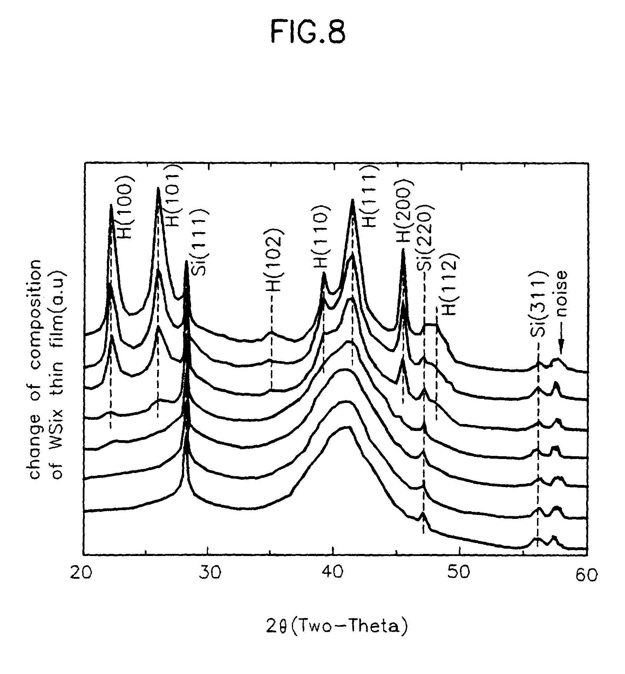

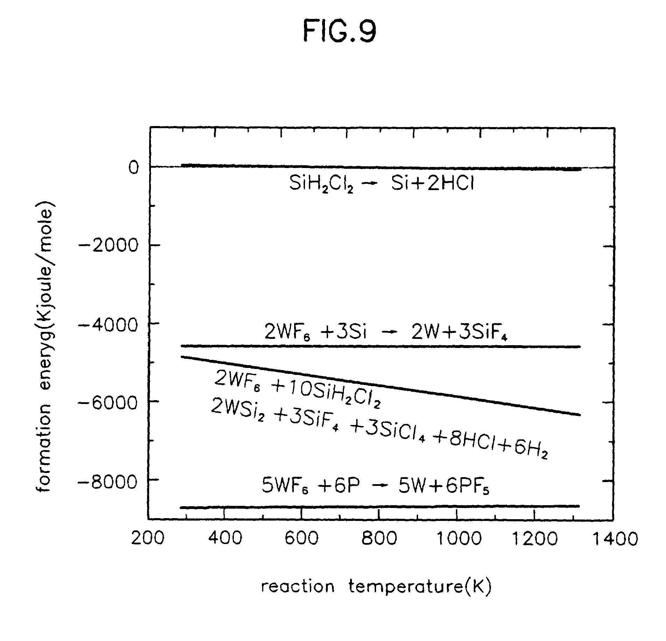

Analysis data on test results of the semiconductor device of the present invention formed according to the aforementioned methods will be explained with reference to the attached drawings. Fig. 6 illustrates a graph showing a $PH_3$ flow rate vs. a resistivity of a tungsten silicide layer(WSix) in deposition of a polysilicon layer according to the method for fabricating a semiconductor device of the present invention, Fig. 7 illustrates a graph showing a sputtering time vs. a silicon atoms/tungsten atoms ratio in a tungsten silicide layer(WSix) for different $PH_3$ flow rates in deposition of a polysilicon layer according to the present invention. Fig. 8 illustrates a graph showing a deposition temperature of a tungsten silicide layer (WSix) vs a composition of the tungsten silicide layer of the present invention and Fig. 9 illustrates a graph showing a reaction temperature of a tungsten silicide layer formed according to different source gases injected into a doped polysilicon layer of the present invention vs. formation energy.

First, changes in resistivity and thickness of a tungsten silicide layer according to a change of a flow rate of $PH_3$ gas in deposition of a polysilicon layer will be discussed.

Referring to Fig. 6, in doping the polysilicon layer, as a concentration of phosphorus(P) is increased, i.e., the $PH_3$ flow rate is increased, a thickness of the tungsten silicide layer(i.e., a deposition rate) is decreased and the resistivity of the tungsten silicide layer is substantially lowered compared to a conventional case. For example, the resistivity is 905 $\mu\Omega \cdot$cm when no $PH_3$ gas presents, and the resistivities are 412 $\mu\Omega \cdot$cm and 310 $\mu\Omega \cdot$cm when the $PH_3$ flow rates are 120 sccm and 240 sccm, respectively.

Next, a change in a composition ratio of silicon atoms vs. tungsten atoms according to a change of a $PH_3$ flow rate in deposition of the polysilicon layer will be discussed. An AES(Auger Electron Spectroscopy) analysis result of the conditions in which a tungsten excess tungsten silicide(WSix) layer is formed at an interface between a doped polysilicon layer and a tungsten silicide layer in formation of the tungsten silicide layer by depositing tungsten on the doped polysilicon layer will be explained.

Referring to Fig. 7, as $PH_3$ is added to a polysilicon layer, increasing a dopant concentration in the polysilicon layer, a tungsten excess layer was appeared at an interface between the tungsten silicide layer and the polysilicon layer; a tungsten silicide layer containing the more tungsten atoms is formed when the $PH_3$ flow rate is the lower if the sputter durations are the same. For example, the tungsten silicide layer contains more tungsten atoms when the $PH_3$ flow rate is 60 sccm than 240 sccm. The composition ratio of silicon atoms to tungsten atoms right after deposition of the tungsten silicide layer is made to be 0.5 - 2.

A composition change of a tungsten silicide layer according to a deposition temperature change of the tungsten silicide layer will be discussed Fig. 8 illustrates an XRD(X-ray diffraction) analysis result of tungsten silicide layers(WSix) deposited at different temperatures while other conditions was kept the same.

Referring to Fig. 8, when the tungsten silicide layers were deposited at different temperatures of 510 deg. C, 525 deg. C, 540 deg. C, 555 deg. C, 570 deg. C, 585 deg. C and 600 deg. C respectively, the tungsten silicide layers deposited at temperatures below 555 deg. C were at amorphous phase and the tungsten silicide layers deposited at temperatures above 555 deg. C were at a phase in which amorphous and crystalline tungsten silicides exist together. And, from the fact that X-rays appear intensive when $2\Theta$(angle) of the tungsten silicide layer are 30 deg. and approx. 40 deg., it can be known that the X-rays are diffracted at those angles where the tungsten silicide layer has a crystal orientation of (111).

Further, the reason why the tungsten silicide layer of the present invention has better resistivity and step coverage will be explained in thermodynamic point of view with reference to Fig. 8. Fig. 9 illustrates a reaction temperature vs. a formation energy($\Delta$G) in case a tungsten silicide layer is formed by a reaction of a doped polysilicon layer with $WF_6$ gas and $SiH_2Cl_2$ gas.

A reaction equation of $WF_6$ gas and P ions to form tungsten(W) and $PF_5$ is as shown below.

$$5WF_6 + 6P \rightarrow 5W + 6PF_5 \text{ -------------------------------------------------------- (1)}$$

And, a reaction equation in formation of the tungsten silicide layer($WSi_2$) is as shown below.

$$2WF_6 + 10SiH_2Cl_2 \rightarrow 2WSi_2 + 3SiF_4 + 3SiCl_4 + 8HCl + 6H_2 \text{ ------------------------ (2)}$$

In the method for forming a tungsten silicide of the present invention since the reaction (equation 1) of forming tungsten and $PF_5$ takes place before the reaction(equation 2) of forming the tungsten silicide, the tungsten excess tungsten silicide layer(WSix) is formed at the end. In this instance, formation enthalpies($\Delta$Hf) of $WSi_2$, $PF_5$ and $WF_6$ are -31.0, -265.73 and 62.48 [kJ/gram.atom], respectively. Because the formation enthalpy of $PF_5$ is substantially stable compared to that of $WSi_2$ or $WF_6$, $PF_5$ is produced in advance. And, as a result of the experiment, it is also found that tungsten is also formed from a reaction caused by phosphorus atoms(P) in the natural oxide film($P_2O_5$) produced on the surface of the doped polysilicon layer when the doped polysilicon layer is exposed to the atmosphere, that is one reason of the tungsten excess tungsten silicide layer formation. The tungsten excess tungsten silicide layer is also formed in a process which involves a polysilicon layer doped with boron(B) or arsenic(As); $BF_3$ and $AsF_3$ are produced on the polysilicon layer doped with boron(B) or arsenic(As) as reaction by-products, of which formation enthalpies being -279.97 and -196.44[kJ/gram.atom], respectively. Because tungsten is produced before the tungsten silicide layer by the formation enthalpies, the tungsten excess tungsten silicide layer is formed. And, according to such a thermodynamic principle, a polycide layer can also be formed even using titanium(Ti) or tantalum(Ta) besides tungsten. In case of titanium, $TiSi_2$ can be formed using $TiCl_4$, $TiI_2$, $SiH_4$, $SiH_2Cl_2$ or the like as a source gas, and, in case of tantalum, $TaSi_2$ can be formed using $TaCl_5$, $SiH_4$, $SiH_2Cl_2$ or the like as a source gas.

The method for forming a semiconductor device of the present invention as explained has the following advantages.

First, the tungsten excess tungsten silicide layer and the silicon nitride film formed in the heat treatment process (especially, in a RTA in an $NH_3$ ambient) after formation of the tungsten silicide layer reduces a resistivity of the tungsten silicide layer, which subsequently improves device performance.

Second, the doping of the polysilicon layer with phosphorus(P), boron(B), or arsenic(As), which have great formation energies, causes tungsten produced in advance in formation of a tungsten silicide layer on the polysilicon layer due to their thermodynamical properties. Because of this, a tungsten excess tungsten silicide layer is formed, which leads to increase a thickness of the tungsten silicide layer stuffed in a contact hole as much as the device packing density becomes greater, that improves a step coverage.

Third, in the case when polysilicon layers are formed on upper and under sides of the tungsten silicide layer, a tungsten silicide layer that is more flat can be obtained, and, diffusion of impurities, such as oxygen, into inner portion of the tungsten silicide layer can be prevented completely during conservation in the atmosphere before heat treatment after deposition of the second polysilicon, that allows conservation of the tungsten silicide layer properties.

It will be apparent to those skilled in the art that various modifications and variations can be made in the method for fabricating a semiconductor device of the present invention without departing from scope of the invention as claimed. Thus, it is intended that the present invention cover the modifications and variations of this invention provided they come within the scope of the appended claims.

## Claims

1. A method for fabricating a semiconductor device, comprising the steps of:

    - forming a doped polysilicon layer (23; 32; 41) on a substrate (21);
    - forming a metal silicide layer (24; 33; 42) containing excessive tungsten on the doped polysilicon layer (23: 32; 41) without breakage of a vacuum for preventing exposure of the doped polysilicon layer (23; 32; 41) to the atmosphere such that a ratio of tungsten atoms (W) to silicon (Si) satisfies the condition of $0.5 \leq x < 2$ in $WSi_x$; and
    - heat treating the silicide layer (24; 33; 42) containing excessive tungsten at a temperature in a range of 400°C to 1,100°C for 30s, so that the excessive tungsten atoms in the first tungsten silicide layer (24; 33; 42) and the doped polysilicon layer (23; 32; 41) make reaction leading to form a second tungsten silicide layer (24a; 33a) having a tetragonal phase crystal structure.

2. A method as claimed in claim 1, further comprising the step of forming a second polysilicon layer (43) on the metal silicide layer (42) containing excessive tungsten.

3. A method as claimed in claims 1 or 2, wherein dopant of the doped polysilicon layer (23; 32; 41) is boron (B), phosphorus (P), or arsenic (As).

4. A method as claimed in claim 2, wherein the doped polysilicon layer (23; 32; 41) is formed using a source gas containing $SiH_4$ and $PH_3$ in a case when the dopant of the doped polysilicon layer is phosphorus (P).

5. A method as claimed in anyone of claims 1 to 4, wherein $WF_6$ and $SiH_4$ or $WF_6$ and $SiH_2Cl_2$ are used as source gases for causing the silicide layer (24; 33; 42) to contain excessive tungsten (W).

6. A method as claimed in anyone of claims 1 to 5, wherein the heat treatment is conducted in a gaseous ambient containing nitrogen atoms for forming a protective film on a surface of the silicide layer containing excessive tungsten.

7. A method as claimed in claim 1 to 2, wherein the silicide layer (24; 33; 42) is formed amorphous.

8. A method as claimed in claim 9, wherein the silicide layer (24; 33; 42) is formed by depositing the silicide layer (24; 33; 42) at a temperature below 555°C for making the silicide layer (24; 33; 42) amorphous.

9. A method as claimed in claim 1, wherein the silicide layer (24; 33; 42) is formed by chemical vapor deposition.

10. A method as claimed in claims 1 or 2, wherein the silicide layer (24; 33; 42) is formed such that amorphous phases and crystalline phases exist therein together.

11. A method as claimed in claim 10, wherein the silicide layer (24; 33; 42) is formed by depositing the silicide layer (24; 33; 42) at a temperature above 555°C for forming the silicide layer (24; 33; 42) containing excessive tungsten and having amorphous phases and crystalline phases existing together.

12. A method as claimed in claim 10, further comprising the step of injecting ions into the silicide layer (24; 33; 42) containing excessive tungsten and having amorphous phases and crystalline phases existing together, for converting the silicide layer (24; 33; 42) of crystalline phase into amorphous phase.

13. A method as claimed in claim 12, wherein the ions are of phosphorus (P), boron (B), or arsenic (As).

14. A method as claimed in claim 13, the injection of ions is conducted to a dose of $1 \times 10^{15}$ cm$^{-3}$ at an ion injection energy of 45-55 KeV in a case of phosphorus (P), 10-20 KeV in a case of boron (B), and 55~65 KeV in case of arsenic (As).

15. A method as claimed in claims 1 or 2, wherein the silicide layer (24; 33; 42) is formed by causing the impurity in the doped polysilicon layer (23; 32; 41) and a fed source gas to make reaction.

16. A method as claimed in claim 15, wherein the fed source gas includes first gas and second gas, whereas a silicide layer (24; 33; 42) containing excessive tungsten is formed both by a metal segregation reaction between the first gas and the impurity in the impurity doped silicon layer (23; 32; 41) and by a silicidation reaction between the first and second gas.

17. A method as claimed in claim 15, wherein the impurity in the impurity doped polysilicon layer (23; 32; 41) is phosphorus (P), boron (B), or arsenic (As).

18. A method as claimed in claim 15, wherein the first gas is $WF_6$, and the second gas is $SiH_4$ or $SiH_2Cl_2$.


**Patentansprüche**

1. Verfahren für die Herstellung einer Halbleitervorrichtung, das die folgenden Schritte umfasst:

   - Bilden einer dotierten Polysiliciumschicht (23; 32; 41) auf einem Substrat (21);
   - Bilden einer Metallsilicidschicht (24; 33; 42), die überschüssiges Wolfram auf der dotierten Polysiliciumschicht (23; 32; 41) ohne Vakuumdurchbruch enthält, um die Aussetzung der dotierten Polysiliciumschicht (23; 32; 41) zur Atmosphäre zu verhindern, derart, dass ein Verhältnis von Wolframatomen W zu Silicium Si die Bedingung $0,5 \leq x < 2$ in $WSi_x$ erfüllt; und
   - Wärmebehandeln der Silicidschicht (24; 33; 42), die überschüssiges Wolfram enthält, bei einer Temperatur im Bereich von 400 °C bis 1100 °C für 30 s, so dass die überschüssigen Wolframatome in der ersten Wolfram-Silicidschicht (24; 33; 42) und die dotierte Polysiliciumschicht (23; 32; 41) miteinander reagieren, was dazu führt, dass eine zweite Wolfram-Silicidschicht (24a; 33a) gebildet wird, die eine Kristallstruktur mit tetragonaler Phase besitzt.

2. Verfahren nach Anspruch 1, das ferner den Schritt des Bildens einer zweiten Polysiliciumschicht (43) auf der Metallsilicidschicht (42), die überschüssiges Wolfram enthält, umfasst.

3. Verfahren nach den Ansprüchen 1 oder 2, wobei der Dotierstoff der dotierten Polysiliciumschicht (23; 32; 41) Bor (B), Phosphor (P) oder Arsen (As) ist.

4. Verfahren nach Anspruch 2, wobei die dotierte Polysiliciumschicht (23; 32; 41) unter Verwendung eines Quellgases gebildet wird, das $SiH_4$ und $PH_3$ enthält, falls der Dotierstoff der dotierten Polysiliciumschicht Phosphor (P) ist.

5. Verfahren nach einem der Ansprüche 1 bis 4, wobei $WF_6$ und $SiH_4$ oder $WF_6$ und $SiH_2Cl_2$ als Quellgase verwendet werden, um zu bewirken, dass die Silicidschicht (24; 33; 42) überschüssiges Wolfram (W) enthält.

**6.** Verfahren nach einem der Ansprüche 1 bis 5, wobei die Wärmebehandlung in einer gasförmigen Umgebung ausgeführt wird, die Stickstoffatome enthält, um auf einer Oberfläche der überschüssiges Wolfram enthaltenden Silicidschicht eine dünne Schutzschicht zu bilden.

**7.** Verfahren nach Anspruch 1 oder 2, wobei die Silicidschicht (24; 33; 42) amorph ausgebildet ist.

**8.** Verfahren nach Anspruch 9, wobei die Silicidschicht (24; 33; 42) durch Ablagern der Silicidschicht (24; 33; 42) bei einer Temperatur unterhalb von 555 °C gebildet wird, um die Silicidschicht (24; 33; 42) amorph zu machen.

**9.** Verfahren nach Anspruch 1, wobei die Silicidschicht (24; 33; 42) durch chemische Abscheidung aus der Dampfphase gebildet wird.

**10.** Verfahren nach den Ansprüchen 1 oder 2, wobei die Silicidschicht (24; 33; 42) in der Weise gebildet wird, dass amorphe Phasen und kristalline Phasen darin gemeinsam existieren.

**11.** Verfahren nach Anspruch 10, wobei die Silicidschicht (24; 33; 42) durch Ablagern der Silicidschicht (24; 33; 42) bei einer Temperatur oberhalb von 555 °C gebildet wird, um die überschüssiges Wolfram enthaltende Silicidschicht (24; 33; 42) zu bilden, die amorphe Phasen und kristalline Phasen, die gemeinsam existieren, besitzt.

**12.** Verfahren nach Anspruch 10, das ferner den Schritt des Injizierens von Ionen in die Silicidschicht (24; 33; 42), die überschüssiges Wolfram enthält und gemeinsam existierende amorphe und kristalline Phasen besitzt, umfasst, um die Silicidschicht (24; 33; 42) der kristallinen Phase in die amorphe Phase umzuwandeln.

**13.** Verfahren nach Anspruch 12, wobei die Ionen Phosphorionen (P), Borionen (B) oder Arsenionen (As) sind.

**14.** Verfahren nach Anspruch 13, wobei das Injizieren von Ionen bis zu einer Dosis von $1 \times 10^{15}$ cm$^{-3}$ bei einer Ioneninjektionsenergie von 45-55 keV im Fall von Phosphor (P), von 10-20 keV im Fall von Bor (B) und von 55-65 keV im Fall von Arsen (As) ausgeführt wird.

**15.** Verfahren nach den Ansprüchen 1 oder 2, wobei die Silicidschicht (24; 33; 42) **dadurch** gebildet wird, dass die Störstellen in der dotierten Polysiliciumschicht (23; 32; 41) und ein zugeführtes Quellgas zum Reagieren veranlasst werden.

**16.** Verfahren nach Anspruch 15, wobei das zugeführte Quellgas ein erstes und ein zweites Gas umfasst, wobei eine Siliciumschicht (24; 33; 42), die überschüssiges Wolfram enthält, sowohl durch eine Metallsegregationsreaktion zwischen dem ersten Gas und den Störstellen in der mit Störstellen dotierten Siliciumschicht (23; 32; 41) als auch durch eine Silicidbildungsreaktion zwischen dem ersten Gas und dem zweiten Gas gebildet wird.

**17.** Verfahren nach Anspruch 15, wobei die Störstellen in der mit Störstellen dotierten Polysiliciumschicht (23; 32; 41) Phosphor (P), Bor (B) oder Arsen (As) sind.

**18.** Verfahren nach Anspruch 15, wobei das erste Gas WF$_6$ ist und das zweite Gas SiH$_4$ oder SiH$_2$Cl$_2$ ist.


**Revendications**

**1.** Procédé pour fabriquer un composant semi-conducteur, comprenant les étapes consistant à :

- former une couche de polysilicium dopé (23 ; 32 ; 41) sur un substrat (21) ;
- former une couche de siliciure de métal (24 ; 33 ; 42) contenant un excès de tungstène sur la couche de polysilicium dopé (23 ; 32 ; 41) sans casser un vide pour empêcher l'exposition de la couche de polysilicium dopé (23 ; 32 ; 41) à l'atmosphère, de telle manière qu'un rapport des atomes de tungstène (W) sur ceux de silicium (Si) satisfait la condition $0,5 \leq x < 2$ dans WSi$_x$ ; et
- traiter à chaud la couche de siliciure (24 ; 33 ; 42) contenant un excès de tungstène à une température dans une plage de 400°C à 1100°C pendant 30 secondes, de sorte que les atomes de tungstène en excès dans la première couche de siliciure de tungstène (24 ; 33 ; 42) et la couche de polysilicium dopé (23 ; 32 ; 41) produisent une réaction menant à la formation d'une seconde couche de siliciure de tungstène (24a ; 33a) ayant une structure de cristal à phase tétragonale.

**2.** Procédé selon la revendication 1, comprenant en outre l'étape consistant à former une seconde couche de polysilicium (43) sur la couche de siliciure de métal (42) contenant un excès de tungstène.

**3.** Procédé selon les revendications 1 ou 2, dans lequel le dopant de la couche de polysilicium dopé (23 ; 32 ; 41) est du bore (B), du phosphore (P), ou de l'arsenic (As).

**4.** Procédé selon la revendication 2, dans lequel la couche de polysilicium dopé (23 ; 32 ; 41) est formée en utilisant une source de gaz contenant $SiH_4$ et $PH_3$ dans un cas dans lequel le dopant de la couche de polysilicium dopé est du phosphore (P).

**5.** Procédé selon l'une quelconque des revendications 1 à 4, dans lequel $WF_6$ et $SiH_4$ ou $VF_6$ et $SiH_2Cl_2$ sont utilisés comme source de gaz pour amener la couche de siliciure (24 ; 33 ; 42) à contenir du tungstène (W) en excès.

**6.** Procédé selon l'une quelconque des revendications 1 à 5, dans lequel le traitement à chaud est mené dans une ambiance gazeuse contenant des atomes d'azote pour former un film protecteur sur une surface de la couche de siliciure contenant du tungstène en excès.

**7.** Procédé selon la revendication 1 ou 2, dans lequel la couche de siliciure (24 ; 33 ; 42) est formée amorphe.

**8.** Procédé selon la revendication 9, dans lequel la couche de siliciure (24 ; 33 ; 42) est formée en déposant la couche de siliciure (24 ; 33 ; 42) à une température au-dessous de 555°C pour rendre la couche de siliciure (24 ; 33 ; 42) amorphe.

**9.** Procédé selon la revendication 1, dans lequel la couche de siliciure (24 ; 33 ; 42) est formée par déposition chimique en phase vapeur.

**10.** Procédé selon les revendications 1 ou 2, dans lequel la couche de siliciure (24 ; 33 ; 42) est formée de telle façon que des phases amorphes et des phases cristallines existent ensemble à l'intérieur.

**11.** Procédé selon la revendication 10, dans lequel la couche de siliciure (24 ; 33 ; 42) est formée en déposant la couche de siliciure (24 ; 33 ; 42) à une température au-dessus de 555°C pour former la couche de siliciure (24 ; 33 ; 42) contenant du tungstène en excès et ayant des phases amorphes et des phases cristallines existant ensemble.

**12.** Procédé selon la revendication 10, comprenant encore l'étape consistant à injecter des ions dans la couche de siliciure (24 ; 33 ; 42) contenant du tungstène en excès et ayant des phases amorphes et des phases cristallines existant ensemble, pour convertir la couche de siliciure (24 ; 33 ; 42) de phase cristalline en phase amorphe.

**13.** Procédé selon la revendication 12, dans lequel les ions sont de phosphore (P), de bore (B) ou d'arsenic (As).

**14.** Procédé selon la revendication 13, dans lequel l'injection des ions est menée à une dose de 1 x $10^{15}$ $cm^{-3}$ avec une énergie d'injection des ions de 45 à 55 KeV dans le cas du phosphore (P), de 10 à 20 KeV dans le cas du bore (B), et de 55 à 65 KeV dans le cas de l'arsenic (As).

**15.** Procédé selon les revendications 1 ou 2, dans lequel la couche de siliciure (24 ; 33 ; 42) est formée en amenant l'impureté dans la couche de polysilicium dopé (23 ; 32 ; 41) et un gaz alimenté depuis une source à entrer en réaction.

**16.** Procédé selon la revendication 15, dans lequel le gaz alimenté depuis une source inclut un premier gaz et un second gaz, de sorte qu'une couche de siliciure (24 ; 33 ; 42) contenant un excès de tungstène est formée à la fois par une réaction de ségrégation de métal entre le premier gaz et l'impureté dans la couche de silicium dopé (23 ; 32 ; 41) et par une réaction de formation de siliciure entre le premier et le second gaz.

**17.** Procédé selon la revendication 15, dans lequel l'impureté dans la couche de polysilicium dopé (23 ; 32 ; 41) est du phosphore (P), du bore (B), ou de l'arsenic (As).

**18.** Procédé selon la revendication 15, dans lequel le premier gaz est du $WF_6$, et le second gaz est du $SiH_4$ ou du $SiH_2Cl_2$.

## FIG.1A
## prior art

## FIG.1B
## prior art

## FIG.1C
## prior art

# FIG.2A
## prior art

10

9

8

1

# FIG.2B
## prior art

11

9

8

1

# FIG.2C
## prior art

12

11

9

8

1

## FIG.3A

## FIG.3B

## FIG.3C

## FIG.4A

## FIG.4B

## FIG.4C

# FIG.4D

# FIG.5

# FIG.6

# FIG.7

# FIG.8

# FIG.9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4504521 A